# EUROPÄISCHE PATENTSCHRIFT

(11) **EP 1 550 359 B1**
(45) Veröffentlichungstag und Bekanntmachung des Hinweises auf die Patenterteilung: **29.03.2006**
(21) Anmeldenummer: 03756479.6
(22) Anmeldetag: 10.10.2003
(51) Int. Cl.: H05K 5/00

(54) **GEHÄUSE FÜR EINEN ANTENNENVERSTÄRKER**
HOUSING FOR ANTENNA AMPLIFIER
BOITIER POUR AMPLIFICATEUR D'ANTENNE

(30) Priorität: 11.10.2002 DE 10247631
(43) Veröffentlichungstag der Anmeldung: 06.07.2005
(73) Patentinhaber: Hirschmann Electronics GmbH & Co. KG, 72654 Neckartenzlingen (DE)
(72) Erfinder: SILVA, David, 72622 Nürtingen (DE)
(74) Vertreter: Thul, Hermann
(86) Internationale Anmeldenummer: PCT/EP2003/011260
(87) Internationale Veröffentlichungsnummer: WO 2004/036970

(56) Entgegenhaltungen:
- EP-A- 0 491 270
- EP-A- 1 221 689
- FR-A- 2 614 169
- US-A- 5 536 917
- US-A- 5 684 274
- US-B1- 6 444 904

## Beschreibung

Die Erfindung betrifft ein Gehäuse, insbesondere aus Kunststoff für eine elektronische Schaltung, insbesondere einen Antennenverstärker zur Anwendung in einem Kraftfahrzeug, gemäß den Merkmalen des Oberbegriffes des Patentanspruches 1.

Elektronische Schaltungen, bei denen auf einer Leiterplatte (Platine) elektronische Bauteile angeordnet sind, werden üblicherweise von einem Gehäuse, das zwecks besserer lsolierung aus Kunststoff besteht, gegen mechanische Beeinflussungen von außen geschützt. Um die Leiterplatte in dem Gehäuse anordnen zu können, besteht das Gehäuse aus zwei gleichartigen oder unterschiedlichen Hälften, wobei auch mehr als zwei Teile denkbar sind. Nach dem Anordnen der Leiterplatte in dem einen Gehäuseteil wird dieses mit dem zumindest einen weiteren Gehäuseteil lösbar oder unlösbar miteinander verbunden. Erfolgt eine unlösbare Verbindung, kommt beispielsweise eine Klebstoffverbindung in Betracht. Dies hat jedoch den Nachteil, daß im Fehlerfalle das Gehäuse zerstört werden muß, um an die Leiterplatte mit ihren Bauteilen zu gelangen.

Bei einer lösbaren Verbindung sind beispielsweise Schraubverbindungen denkbar. Diese haben jedoch den Nachteil, daß zur Verbindung der beiden Gehäuseteile Werkzeug sowie zusätzliche Befestigungsmittel erforderlich sind. Dies erhöht die nötigen Bauteile und damit verbunden den Montageaufwand. Weiterhin sind Schnappverbindungen bekannt, bei denen Rasthaken an dem einen Gehäuseteil in entsprechende Ausnehmungen an dem anderen Gehäuseteil eingreifen. Diese haben jedoch den Nachteil, daß sie die beiden Gehäuseteile nicht ausreichend fest miteinander verbinden, so daß trotz Verbindung über den Schnappverschluß sich die beiden Gehäuseteile noch relativ zueinander bewegen können, was zu einer unerwünschten Geräuschkulisse führt. Außerdem ist dadurch die Dichtheit zwischen den beiden Gehäuseteilen nicht gewährleistet, so daß insbesondere Feuchtigkeit oder Spritzwasser in das Innere des Gehäuses eindringen kann. Andererseits besteht bei solchen Schnappverbindungen die Gefahr, daß sie nicht ausreichend oder gar nicht einrasten, so daß zwar optisch der Eindruck entsteht, daß die beiden Gehäuseteile miteinander verbunden sind, jedoch im Betrieb, insbesondere bei Vibrationen, sich die beiden Gehäuseteile voneinander lösen können.

Der Erfindung liegt daher die Aufgabe zugrunde, ein Gehäuse aus zumindest zwei Teilen zur Aufnahme einer Leiterplatte mit elektronischen Bauteilen, insbesondere eines Antennenverstärkers für ein Kraftfahrzeug, bereitzustellen, bei dem die zumindest zwei Gehäuseteile durch eine Schnappverbindung zuverlässig miteinander verbindbar sind.

Diese Aufgabe ist durch die Merkmale des Patentanspruches 1 gelöst.

Erfindungsgemäß ist vorgesehen, dass die zumindest eine Schnappverbindung derart gestaltet ist, dass sie nach dem Verrasten unter Vorspannung steht, wozu an den einen Gehäuseteil ein elastisch nachgebbares Schnappteil und an dem zumindest einem weiteren Gehäuseteil ein mit dem Schnappteil in Wirkverbindung bringbares Teil angeordnet ist. Dabei ist das elastisch nachgebbare Schnappteil derart ausgebildet, dass es nach dem Zusammenbringen der zumindest beiden Gehäuseteile erst dann eine Verbindung mit dem korrespondierenden Teil eingeht, wenn es eine mechanische Einwirkung, insbesondere eine Druckausübung, erfahren hat. Diese derartige Schnappverbindung zum Verbinden der zumindest beiden Gehäuseteile miteinander hat den Vorteil, dass sie ohne zusätzliche Bauteile einfach zu montieren ist, indem nämlich die zumindest beiden Gehäuseteile zusammengebracht und auf das Schnappteil gedrückt wird. Dadurch rastet dieses Schnappteil an dem korrespondierenden Teil an dem anderen Gehäuseteil ein und verbindet die beiden Gehäuseteile zuverlässig miteinander. Durch die Druckausübung auf das Schnappteil steht nach dem Zusammenbringen die gesamte Schnappverbindung unter einer gewissen Vorspannung, so dass die zumindest beiden Gehäuseteile zuverlässig aneinander anliegen und sich nicht mehr relativ zueinander bewegen können. Ein weiterer Vorteil der Erfindung besteht darin, dass nach Druckausübung auf das Schnappteil an dem einen Gehäuseteil während des Einrastens an dem korrespondierenden Teil ein Geräusch (Klacken) zu hören ist, wodurch für das Montagepersonal eine Rückmeldung gegeben ist, dass die Schnappverbindung zuverlässig eingerastet hat. Gleiches gilt auch für den automatisierten Zusammenbau der zumindest beiden Gehäusehälften. Die Vorspannung, unter der die zumindest beiden Gehäuseteile stehen, hat darüber hinaus den Vorteil, dass sie auch im Dauereinsatz und unter harten Umgebungsbedingungen, wie sie insbesondere in einem Fahrzeug herrschen, zuverlässig zusammenhalten, ohne dass Geräusche auf Grund einer Relativbewegung der zumindest beiden Gehäuseteile entstehen können. Ebenso ist der Vorteil der erfindungsgemäßen Schnappverbindung, dass die zumindest beiden Gehäuseteile durch Lösen der Schnappverbindung wieder voneinander trennbar sind, um ein in dem Gehäuse befindliches elektronisches Gerät z.B. im Defektfall austauschen zu können.

Ein Ausführungsbeispiel des erfindungsgemäßen Gehäuses, auf das die Erfindung jedoch nicht beschränkt ist, ist im Folgenden beschrieben und anhand der Figuren erläutert.

Es zeigen:
- Figur 1:: Zwei Gehäuseteile in Innenansicht
- Figur 2:: Zwei Gehäuseteile in Außenansicht

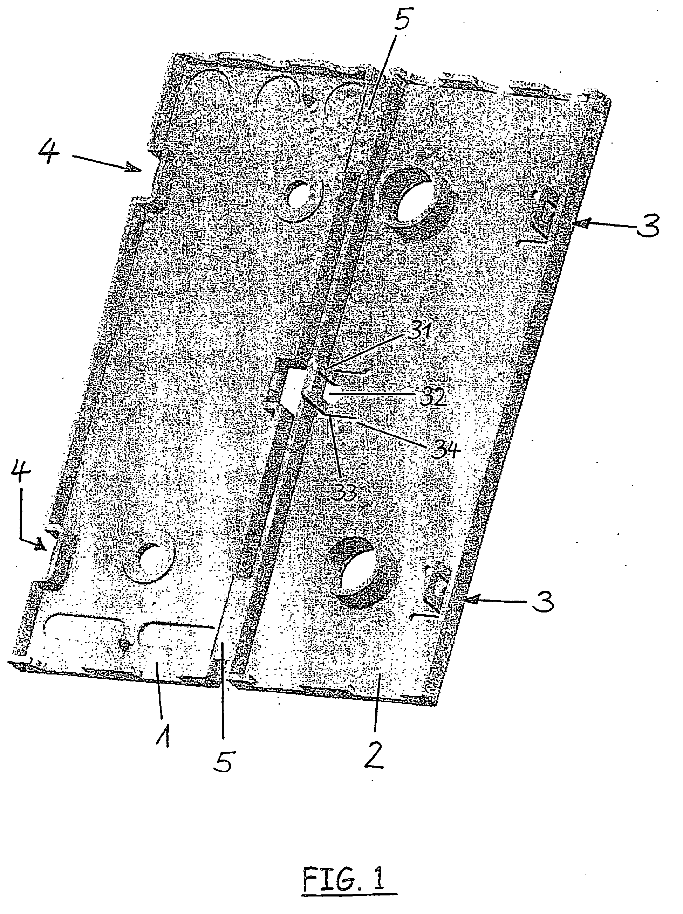

Figur 1 zeigt die beispielhafte geometrische Ausführung von zwei Gehäuseteilen, 1, 2, wobei die Erfindung unabhängig von den geometrischen Abmessungen der Gehäuseteile 1, 2 anwendbar ist. Nicht gezeigt ist in Figur 1 das elektronische Gerät, das von den beiden Gehäuseteilen 1, 2 umgebbar ist, wobei es sich bei dem elektronischen Gerät z.B. um einen Antennenverstärker, ein Videomodul oder dergleichen für das Senden und Empfangen von Signalen von einem Fahrzeug aus oder zu dem Fahrzeug hinein eingesetzt wird. Bevorzugtes Anwendungsgebiet des erfindungsgemäße Gehäuses ist die Fahrzeugtechnik, da hier rauhe Umgebungsbedingungen wie Temperaturschwankungen, Vibrationen und dergleichen herrschen, so dass es bei diesem bevorzugten Anwendungsgebiet von besonderer Wichtigkeit ist, dass die beiden (oder mehr als zwei) Gehäuseteile 1, 2 zuverlässig und dauerhaft miteinander verbunden werden. Zu diesem Zweck ist das erfindungsgemäße Schnappteil 3 einmal oder mehrmals an einem Gehäuseteil, hier bei Figur 1 an dem Gehäuseteil 2, vorhanden. In dem gezeigten Ausführungsbeispiel ist das Schnappteil an dem Gehäuseteil 2 eine Lasche 31 mit einer Ausnehmung 32, wobei die Lasche 31 in diesem Ausführungsbeispiel abgewinkelt ist. Diese Abwinklung ist realisiert durch Schlitze 33, die in die Oberfläche des Gehäuseteiles 2 hinein ragen, so dass die Lasche 31 längsseitig über Schlitze 33 von dem Gehäuseteil 2 getrennt und nur mit einem Endbereich mit dem Gehäuseteil 2 verbunden ist. Eine derartige Lasche 31 ist damit bewegbar an dem Gehäuseteil 2 angeordnet, wozu am Ende eines Schlitzes 33 noch eine Aufweitung 34 vorhanden sein kann, um ein Abreißen der Lasche 31 bei ihrer Bewegung zu vermeiden.

Als mit dem Schnappteil an dem Gehäuseteil 2 korrespondierendes Teil ist mit dem Schnappteil an dem Gehäuseteil 2 ein korrespondierendes Schnappteil 4 an dem Gehäuseteil 1 vorhanden. Die beiden Schnappteile 3, 4 bilden die Schnappverbindung, so dass das Schnappteil mit dem Schnappteil 4 in Wirkverbindung gebracht werden kann. Dabei ist in besonders vorteilhafter Weise das Schnappteil 4 in einem gegenüber der Oberfläche des Gehäuseteils 1 zurückgesetzten Bereiches 41 angeordnet, wobei in diesem zurückgesetzten Bereich 41 ein Rasthaken 42 angeordnet ist, der mit der Ausnehmung 32 der abgewinkelten Lasche 31 in Wirkverbindung gebracht werden kann.

Die in Figur 1 gezeigten Gehäuseteile 1, 2 sind entweder getrennt voneinander oder zusammen herstellbar, wobei dann in besonders vorteilhafter Weise während der Herstellung der beiden Gehäuseteile 1, 2 dazwischen ein Filmscharnier 5 (Allgemein-Verbindungsmittel) vorhanden sind. Das Filmscharnier 5 hat den Vorteil, dass die beiden Gehäuseteile 1, 2 nur mit dem elektronischen Gerät (insbesondere Schaltungsplatine mit elektronische Bauteilen und Steckverbindungen sowie Kontaktstellen) zusammen geklappt und über die beiden Schnappteile 3, 4 miteinander verbunden werden müssen. Dies kann sehr einfach und sehr schnell manuell oder automatisiert erfolgen. Denkbar ist auch, dass beispielsweise entlang der Längskante der beiden Gehäuseteile 1 und 2 eine Dichtung vorgesehen ist. Gleiches gilt für Führungselemente (wie beispielsweise Stifte und korrespondierende Bohrungen oder dergleichen), die einerseits die Festlegung des elektronischen Gerätes in einem der beiden Gehäuseteile 1, 2 und die Festlegung der beiden Gehäuseteile 1, 2 zueinander bewirken. Solche Führungselemente sind insbesondere dann erforderlich, wenn die beiden Gehäuseteile 1, 2 nicht über Verbindungsmittel (wie beispielsweise dem Filmscharnier 5) miteinander verbunden sind.

In besonders vorteilhafter Weise sind die zumindest beiden Gehäuseteile 1, 2 in einem Kunststoff-Spritzgussverfahren hergestellt, welches es durch eine entsprechende Formgebung gestattet, sämtliche konstruktive Ausgestaltungen der beiden Gehäuseteile 1, 2 in einem Herstellvorgang zu realisieren. Dies gilt insbesondere für die Schnappteile 3, 4, die schon nach dem Herstellen der beiden Gehäuseteile 1, 2 an diesen vorhanden sind. In besonders vorteilhafter Weise entfällt damit eine Nachbearbeitung.

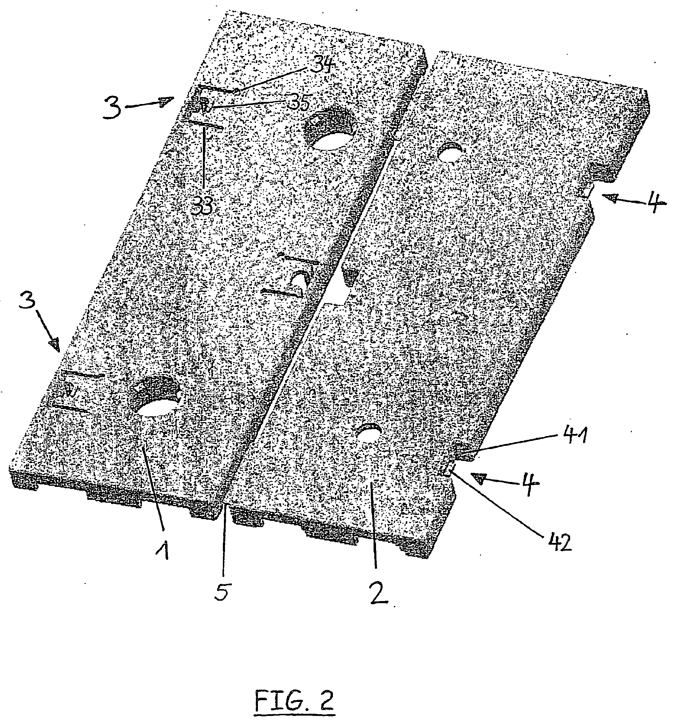

Figur 2 zeigt ergänzend die Draufsicht auf die beiden Gehäuseteile 1, 2, wobei in besonders vorteilhafter Weise die zueinander korrespondierende Lage der Schnappteile 3, 4 zu erkennen ist. Hierbei ist noch auf folgende wichtige Details hinzuweisen:

Das Schnappteil 3 beispielsweise an dem Gehäuseteil 2 kann, muss aber nicht, in einem zurückgesetzten Bereich 41 angeordnet sein. Innerhalb dieses zurückgesetzten Bereiches ist ein Rasthaken 42 vorhanden, der in Wirkverbindung mit der Ausnehmung 32 der abgewinkelten Lasche 31 bringbar ist. Durch die entsprechende Form der Lasche 31 und ihrer Anordnung innerhalb des Gehäuseteiles 1, insbesondere auf Grund der Schlitze 33, ist diese aus der Ebene der Oberfläche des Gehäuseteiles 1 auslenkbar. Dabei sind die geometrischen Abmessungen, insbesondere die Lage der Lasche 31 zu dem Rasthaken 42 so gestaltet, dass beim Zusammenklappen der beiden Gehäuseteile 1, 2 um das Filmscharnier 5 (oder das sonstige Zusammensetzen) noch nicht das Einrasten der Lasche 31 an dem Rasthaken 42 bewirkt.

Dieses Einrasten wird in besonders vorteilhafter Weise erst durch mechanische Druckausübung auf die Lasche 31, die für diesen Zweck insbesondere einen Vorsprung 35 aufweist, erzielt. Dabei wird die Lasche 31 über den Rasthaken 42 gedrückt und kann an diesem einschnappen (einrasten). Dadurch steht diese Schnappverbindung ständig unter Vorspannung und verspannt die beiden Gehäuseteile 1, 2 miteinander. Um die Druckausübung auf die Lasche 31 zu vereinfachen, ist der Vorsprung 35 vorgesehen, über den die Lasche 31 mit der Hand (z.B. Daumen oder Zeigefinger) oder mit einen Werkzeug, ggfs. auch automatisiert, niedergedrückt werden kann. Von besonderem Vorteil ist eben die Vorspannung, die mit der erfindungsgemäßen Schnappverbindung, insbesondere realisiert durch die Lasche 31 und den Rasthaken 42, bewirkt wird.

### Bezugszeichenliste:

- 1: Gehäuseteil
- 2: Gehäuseteil
- 3: Schnappteil
- 31: Abgewinkelte Lasche
- 32: Ausnehmung
- 33: Schlitz
- 34: Aufweitung
- 35: Vorsprung
- 4: Schnappteil
- 41: Zurückgesetzer Bereich
- 42: Rasthaken
- 5: Filmscharnier

## Patentansprüche

1. Gehäuse, insbesondere ein Gehäuse für ein elektronisches Gerät zur Anwendung in der Fahrzeugtechnik, das zumindest zwei Gehäuseteile (1, 2) aus Kunststoff aufweist, wobei die beiden Gehäuseteile (1, 2) über zumindest eine Schnappverbindung miteinander verrastbar sind, **dadurch gekennzeichnet, dass** die zumindest eine Schnappverbindung derart gestaltet ist, dass sie nach dem Verrasten unter Vorspannung steht, wozu an dem einen Gehäuseteil (2) ein elastisch nachgebbares Schnappteil (3) und an dem zumindest einen weiteren Gehäuseteil (1) ein mit dem Schnappteil (3) durch Ausübung einer Kraft auf das Gehäuse im Bereich der Schnappverbindung in Wirkverbindung bringbares Schnappteil (4) angeordnet ist.

2. Gehäuse nach Anspruch 1, **dadurch gekennzeichnet, dass** das Schnappteil (3) an dem Gehäuseteil (2) eine Lasche (31) mit einer Ausnehmung (32) und das damit in Wirkverbindung bringbare Schnappteil (4) an dem Gehäuseteil (1) ein Rasthaken (42) ist.

3. Gehäuse nach Anspruch 2, **dadurch gekennzeichnet, dass** die Lasche (31) über Schlitze (33) von dem Gehäuseteil (2) getrennt und nur mit einem Endbereich mit dem Gehäuseteil (2) verbunden ist.

4. Gehäuse nach Anspruch 1 oder 2, **dadurch gekennzeichnet, dass** die Lasche (31) einen nach außen gerichteten Vorsprung (35) aufweist.

5. Gehäuse nach Anspruch 2, 3 oder 4, **dadurch gekennzeichnet, dass** der Rasthaken (42) in einem gegenüber der Oberfläche des Gehäuseteiles (1) zurückversetzten Bereich (41) angeordnet ist.

6. Gehäuse nach einem der vorhergehenden Ansprüche, **dadurch gekennzeichnet, dass** die zumindest zwei Gehäuseteile (1, 2) getrennt oder über Verbindungsmittel miteinander verbunden sind.

7. Gehäuse nach Anspruch 6, **dadurch gekennzeichnet, dass** die Verbindungsmittel zumindest ein Filmscharnier (5) sind.

8. Gehäuse nach einem der vorhergehenden Ansprüche, **dadurch gekennzeichnet, dass** die zumindest zwei Gehäuseteile (1, 2) in einem Kunststoff-Spritzgussverfahren hergestellt sind.

## Claims

1. Housing, in particular a housing for an electronic appliance for use in vehicle engineering, which has at least two plastic housing parts (1, 2) in which case the two housing parts (1, 2) can be latched to one another via at least one snap-action connection, **characterized in that** the at least one snap-action connection is designed in such a way that it is prestressed after latching, for which purpose an elastically flexible snap-action part (3) is arranged on one housing part (2) and a snap-action part (4), which can be operatively connected to the snap-action part (3) by exertion of a force on the housing in the area of the snap-action connection, is arranged on the at least one further housing part (1).

2. Housing according to Claim 1, **characterized in that** the snap-action part (3) on the housing part (2) is a lug (31) with a recess (32), and the snap-action part (4) which can be operatively connected to it on the housing part (1) is a latching hook (42).

3. Housing according to Claim 2, **characterized in that** the lug (31) is separated from the housing part (2) by slots (33), and is connected only by an end area to the housing part (2).

4. Housing according to Claim 1 or 2, **characterized in that** the lug (31) has a projection (35) which points outwards.

5. Housing according to Claim 2, 3 or 4, **characterized in that** the latching hook (42) is arranged in an area (41) which is recessed with respect to the surface of the housing part (1).

6. Housing according to one of the preceding claims, **characterized in that** the at least two housing parts (1, 2) are separate, or are connected to one another via connecting means.

7. Housing according to Claim 6, **characterized in that** the connecting means are at least one film hinge (5).

8. Housing according to one of the preceding claims, **characterized in that** the at least two housing parts (1, 2) are produced using a plastic injection-moulding process.

## Revendications

1. Boîtier, en particulier un boîtier pour un appareil électronique à utiliser en technique automobile, qui présente au moins deux parties de boîtier (1, 2) en matière plastique, sachant que les deux parties de boîtier (1, 2) peuvent être verrouillées entre elles au moyen d'au moins un assemblage à enclenchement, **caractérisé en ce que** l'assemblage à enclenchement au moins unique est conçu de telle sorte qu'il se trouve sous précontrainte à la suite du verrouillage, sachant qu'à cet effet, un élément d'enclenchement (3) pouvant céder élastiquement est disposé sur l'une (2) des parties de boîtier, et un élément d'enclenchement (4) est disposé sur l'autre partie de boîtier (1) au moins unique, élément qui peut être amené en liaison fonctionnelle avec l'élément d'enclenchement (3) en exerçant une force sur le boîtier dans la région de l'assemblage par enclenchement.

2. Boîtier selon la revendication 1, **caractérisé en ce que** l'élément d'enclenchement (3) sur la partie de boîtier (2) est une patte (31) pourvue d'un évidement (32), et l'élément d'enclenchement (4), qui peut être amené en liaison fonctionnelle avec lui, sur la partie de boîtier (1) est un crochet de crantage (42).

3. Boîtier selon la revendication 2, **caractérisé en ce que** la patte (31) est séparée de la partie de boîtier (2) par des fentes (33) et n'est reliée à la partie de boîtier (2) que par une région terminale.

4. Boîtier selon la revendication 1 ou 2, **caractérisé en ce que** la patte (31) présente une saillie (35) dirigée vers l'extérieur.

5. Boîtier selon la revendication 2, 3 ou 4, **caractérisé en ce que** le crochet de crantage (42) est disposé dans une région (41) en retrait par rapport à la surface de la partie de boîtier (1).

6. Boîtier selon l'une quelconque des revendications précédentes, **caractérisé en ce que** les parties de boîtier (1,2), qui sont au moins au nombre de deux, sont séparées ou sont mutuellement assemblées par des moyens d'assemblage.

7. Boîtier selon la revendication 6, **caractérisé en ce que** les moyens d'assemblage consistent en au moins une charnière pelliculaire (5).

8. Boîtier selon l'une quelconque des revendications précédentes, **caractérisé en ce que** les parties de boîtier (1,2), qui sont au moins au nombre de deux, sont fabriquées par un procédé de moulage par injection de matière plastique.
